# EUROPEAN PATENT SPECIFICATION

(11) **EP 2 562 824 B1**
(45) Date of publication and mention of the grant of the patent: **26.09.2018**
(21) Application number: 10850131.3
(22) Date of filing: 06.11.2010
(51) Int. Cl.: H01L 31/05, H01L 31/02, H01L 31/042

(54) **CIRCUIT STACK STRUCTURE OF PHOTOVOLTAIC ASSEMBLY**
SCHALTUNGSSTAPELSTRUKTUR FÜR EINE FOTOVOLTAIKANLAGE
STRUCTURE DE CIRCUITS EMPILÉS D'UN ENSEMBLE PHOTOVOLTAÏQUE

(30) Priority: 20.04.2010 CN 201010152169
(43) Date of publication of application: 27.02.2013
(73) Proprietor: Changzhou Trina Solar Energy Co., Ltd., Changzhou, Jiangsu 213031 (CN)
(72) Inventor: XU, Jianmei, Changzhou Jiangsu 213031 (CN)
(74) Representative: Bergenstråhle Group AB
(86) International application number: PCT/CN2010/078482
(87) International publication number: WO 2011/130999

(56) References cited:
- EP-A2- 2 056 357
- CN-U- 201 655 820
- CN-Y- 201 215 809
- CN-Y- 201 392 843
- JP-A- 9 260 707
- JP-A- 2009 111 034
- US-A1- 2003 006 730

## Description

### Field of the Invention

The present invention relates to the field of circuit stack for solar photovoltaic assembly, especially a circuit stack structure for photovoltaic assembly.

### Description of the Prior art

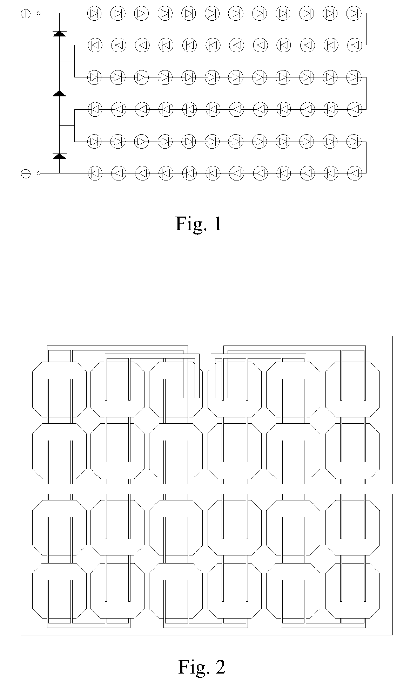

The existing circuit stack of photovoltaic assembly is generally carried out according to the circuit connection diagram and the stack structure diagram, the circuit connection diagram of solar photovoltaic assembly is shown in Figure 1, the solar photovoltaic assembly consists of six solar cell strings, each solar cell string is formed by multiple solar cell chips connected in series, each of the two solar cell strings are connected in series with each other. The bypass diodes are reversely connected between each of the two solar cell strings. The leading solar cell chip of each of the six solar cell strings on the back of photovoltaic assembly are first solar cell chip, second solar cell chip, third solar cell chip, fourth solar cell chip, fifth solar cell chip and sixth solar cell chip 6 respectively from the left hand side to the right hand side.

Document US2003006730 discloses a photovoltaic assembly.

The stack structure diagram of photovoltaic assembly is shown in Figure 2, which is a diagram of the rear surface of the photovoltaic assembly, wherein the back electrode of the solar cell chip is the positive electrode of the solar cell chip, the front electrode of the solar cell chip is the negative electrode of the solar cell chip. The bus bars used for leading out the electrodes are categorized into the first long bus bar, the second long bus bar, the first short bus bar and the second short bus bar. The left end of the first long bus bar is connected to the front electrode of the first solar cell chip by solder, and the right end of the second long bus bar is connected to the back electrode of the sixth solar cell chip by solder.

The left end of the first short bus bar is connected to the back electrode of the second solar cell chip by solder, and the right end is connected to the front electrode of the third solar cell chip by solder. The left end of the second short bus bar is connected to the back electrode of the fourth solar cell chip by solder, and the right end is connected to the front electrode of the fifth solar cell chip by solder.

Because the first long bus bar is only connected to the first solar cell chip by solder which is leftmost, the second long bus bar is only connected to the sixth solar cell chip by solder which is rightmost, and the first long bus bar and the second long bus bar are relatively long, in the process of laminating the photovoltaic assembly, the first long bus bar and the second long bus bar can be easily shifted, and it's easy for them to get close to the solar cell chips and the first short bus bar and the second short bus bar, thereby causing badness in the assembly. Moreover, the first long bus bar and the second long bus bar are arranged in parallel with the first short bus bar and the second short bus bar, which increases the area of the assembly and its manufacturing cost.

### Summary of the Invention

The technical problem to be solved by the present invention is: to overcome the deficiencies in the prior art, and provide a circuit stack structure for a photovoltaic assembly, wherein the longer bus bar is not easy to be shifted and it's not easy to cause badness in the assembly in the process of laminating the assembly.

The technical solution adopted by the present invention to solve the technical problem is: a circuit stack structure for a photovoltaic assembly, which has a photovoltaic assembly frame and a photovoltaic assembly installed in the photovoltaic assembly frame, the photovoltaic assembly has six solar cell strings and bus bars, each solar cell string is formed by connecting multiple solar cell chips in series, the leading solar cell chip of each of the six solar cell strings on the back of the photovoltaic assembly are first solar cell chip, second solar cell chip, third solar cell chip, fourth solar cell chip, fifth solar cell chip and sixth solar cell chip respectively from left hand side to the right hand side;
the bus bars are categorized into long bus bars and short bus bars, the long bus bars are categorized into first long bus bar and second long bus bar, the short bus bars are categorized into first short bus bar and second short bus bar;
the left end of the first long bus bar is connected to the first solar cell chip by solder, and the right end of the first long bus bar is connected to the third solar cell chip by solder;
the left end of second long bus bar is connected to the fourth solar cell chip by solder, and the right end of the second long bus bar is connected to the sixth solar cell chip by solder;
the left end of the first short bus bar is connected to the second solar cell chip by solder, and the right end of the first short bus bar is used as the leading end of an electrode of the photovoltaic assembly;
the left end of second short bus bar is connected to the fifth solar cell chip by solder, and the right end of the second short bus bar is used as the leading end of an electrode of the photovoltaic assembly.

Specifically, the left end of the first long bus bar is connected to the back electrode of the first solar cell chip solder, and the right end of the first long bus bar is connected to the front electrode of the third solar cell chip by solder;
the left end of the second long bus bar is connected to the back electrode of the fourth solar cell chip by solder, and the right end of second long bus bar is connected to the front electrode of the sixth solar cell chip by solder;
the left end of first short bus bar is connected to the front electrode of the second solar cell chip by solder, and the right end of first short bus bar is used as the leading end of a negative electrode of the photovoltaic assembly;
the left end of the second short bus bar is connected to the back electrode of the fifth solar cell chip by solder, and the right end of the second short bus bar is used as the leading end of a positive electrode of the photovoltaic assembly.

Further, bypass diodes are reversely connected between the first solar cell chip and the second solar cell chip, the third solar cell chip and the fourth solar cell chip, the fifth solar cell chip and the sixth solar cell chip.

Further, the long bus bars and the short bus bars are located on the back of the solar cell strings, this not only improves the frontal visual effect of the assembly, but also reduce the size of the assembly, the length can be shortened by 10 ∼ 20mm, this reduces the cost of materials. If the size of the assembly keeps the same, then it can increase the distance from the charged body inside the assembly to the edge of the glass, and improve the long-term reliability of the assembly.

Further, the long bus bars and the short bus bars are overlapped up and down, spaced by EVA and TPT in the middle, this increases the distance from the charged body inside the assembly to the edge of the glass, and improves the long-term reliability of the assembly.

The beneficial effects of the present invention are: the left and right end of the first long bus bar and the second long bus bar in the present invention are both fixed to the solar cell chips, in the process of laminating the photovoltaic assembly, the first long bus bar and the second long bus bar are not easy to be shifted, so it is not easy for the long bus bar to get close to the short bus bars and the solar cell chips, which is not easy to cause badness in the assembly and improves yield of the assembly.

### Brief Description of the Drawings

The following Drawings will further illustrate the present invention.
Figure 1 is the circuit connection diagram of the prior art;
Figure 2 is the stack structure diagram of the prior art;
Figure 3 is the circuit connection diagram of the present invention;
Figure 4 is the stack structure diagram of the present invention;
wherein: 1. first solar cell chip, 2. second solar cell chip, 3. third solar cell chip, 4. fourth solar cell chip, 5. fifth solar cell chip, 6. sixth solar cell chip, 7. first long bus bar, 8 second long bus bar, 9. first short bus bar, 10. second short bus bar

### Detailed Description of the Preferred Embodiments

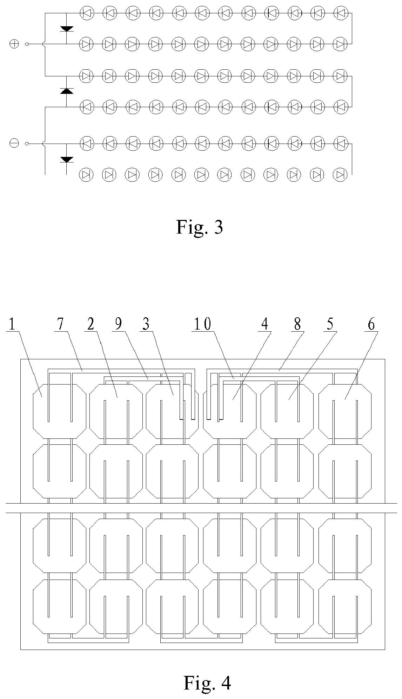

The circuit stack structure for a photovoltaic assembly is shown in Figure 4, which is the rear surface diagram of the photovoltaic assembly, and Figure 3 is the circuit connection diagram of the present invention, the circuit stack of a photovoltaic assembly of the present invention is completed according to the circuit connection diagram in Figure 3.

The circuit stack structure for a photovoltaic assembly, as shown in Figure 4, has a photovoltaic assembly frame and a photovoltaic assembly installed in the photovoltaic assembly frame, the photovoltaic assembly includes six solar cell strings and bus bars, each solar cell string is formed by connecting 10 or 12 solar cell chips in series, the back electrode of the solar cell chip is the positive electrode of the solar cell chip, the front electrode of the solar cell chip is the negative electrode of the solar cell chip, each of the two solar cell strings is connected to the other, the leading solar cell chip of each of the six solar cell strings on the back of the photovoltaic assembly are first solar cell chip 1, second solar cell chip 2, third solar cell chip 3, fourth solar cell chip 4, fifth solar cell chip 5 and sixth solar cell chip 6 respectively from the left hand side to the right hand side.

The bus bars are categorized into long bus bars and short bus bars, the long bus bars are categorized into first long bus bar 7 and second long bus bar 8, the short bus bars are categorized into first short bus bar 9 and second short bus bar 10;

The left end of the first long bus bar 7 is connected to the back electrode of the first solar cell chip 1 by solder, and the right end of the first long bus bar 7 is connected to the front electrode of the third solar cell chip 3 by solder.

The left end of the second long bus bar 8 is connected to the back electrode of the fourth solar cell chip 4 by solder, and the right end of the second long bus bar 8 is connected to the front electrode of the sixth solar cell chip 6 by solder.

The left end of the first short bus bar 9 is connected to the front electrode of the second solar cell chip 2 by solder, and the right end of the first short bus bar 9 is used as the leading end of the negative electrode of the photovoltaic assembly;

The left end of the second short bus bar 10 is connected to the back electrode of the fifth solar cell chip 5 by solder, and the right end of the second short bus bar 10 is used as the leading end of the positive electrode of the photovoltaic assembly;

The leading end of the first long bus bar 7 and that of the second long bus bar 8 are located within the interval between the leading end of the first short bus bar 9 and that of the second short bus bar 10;

Bypass diodes are reversely connected between the first solar cell chip 1 and the second solar cell chip 2, the third solar cell chip 3 and the fourth solar cell chip 4, the fifth solar cell chip 5 and the sixth solar cell chip 6;

The long bus bars and the short bus bars are located on the back of the solar cell strings. The long bus bars and the short bus bars are overlapped up and down, spaced by EVA and TPT in the middle.

The circuit connection diagram is shown as figure 3, compared with the prior art as shown in Figure 1, it has adjusted the order of the positive electrodes and the negative electrodes of each solar cell string, i.e., the solar cell string of the first column and the solar cell string of the second column are interchanged with each other, the solar cell string of the fifth column and the solar cell string of the sixth column are interchanged with each other, so the first long bus bar 7 and the second long bus bar 8 can be connected to the two columns of solar cell strings by solder respectively, the adjusted solar cell string in the second column and the solar cell string in the fifth column are connected to the short bus bars by solder, and they are used as leading ends of the electrodes of the photovoltaic assembly,

Compared with the prior art, from the perspective of circuit design, the present invention have the left and right ends of the first long bus bar 7 and the second long bus bar 8 fixed to the solar cell chip by adjusting the orders of the positive electrodes and the negative electrodes of each solar cell string, therefore, the first long bus bar 7 and the second long bus bar 8 are not easy to be shifted in the process of laminating the photovoltaic assembly, so the long bus bars are not easy to get close to the short bus bars and the solar cell chips, this is not easy to cause badness in the assembly, which improves yield of the assembly.

## Claims

1. A circuit stack structure for a photovoltaic assembly, comprising a photovoltaic assembly frame in which the photovoltaic assembly is installed, the photovoltaic assembly having six solar cell strings and bus bars, each solar cell string being formed by connecting multiple solar cell chips in series, and the leading solar cell chip of each of the six solar cell strings on the back of the photovoltaic assembly being, from left to right, a first solar cell chip (1), a second solar cell chip (2), a third solar cell chip (3), a fourth solar cell chip (4), a fifth solar cell chip (5) and a sixth solar cell chip (6);
the bus bars being categorized into long bus bars and short bus bars, the long bus bars being categorized into first long bus bar (7) and second long bus bar (8), and the short bus bars being categorized into first short bus bar (9) and second short bus bar (10),
**characterized by** the left end of the first long bus bar (7) being connected to the first solar cell chip (1) by solder, and the right end of the first long bus bar (7) being connected to the third solar cell chip (3) by solder;
the left end of the second long bus bar (8) being connected to the fourth solar cell chip (4) by solder, the right end of the second long bus bar (8) being connected to the sixth solar cell chip (6) by solder; the left end of the first short bus bar (9) being connected to the second solar cell chip (2) by solder, the right end of the first short bus bar (9) being used as a leading end of a electrode of the photovoltaic assembly;
the left end of the second short bus bar (10) being connected to the fifth solar cell chip (5) by solder, the right end of the second short bus bar (10) being used as a leading end of a electrode of the photovoltaic assembly.

2. The circuit stack structure for a photovoltaic assembly according to claim 1, **characterized by** the left end of the first long bus bar (7) being connected to a back electrode of the first solar cell chip (1) by solder, the right end of the first long bus bar (7) being connected to a front electrode of the third solar cell chip (3) by solder;
the left end of the second long bus bar (8) being connected to a back electrode of the fourth solar cell chip (4) by solder, the right end of the second long bus bar (8) being connected to a front electrode of the sixth solar cell chip (6) by solder;
the left end of the first short bus bar (9) being connected to a front electrode of the second solar cell chip (2) by solder, the right end of the first short bus bar (9) being used as a leading end of a negative electrode of the photovoltaic assembly;
the left end of the second short bus bar (10) being connected to a back electrode of the fifth solar cell chip (5) by solder, the right end of the second short bus bar (10) being used as a leading end of the positive electrode of the photovoltaic assembly.

3. The circuit stack structure for the photovoltaic assembly according to claim 1, **characterized by** bypass diodes being reversely connected between the first solar cell chip (1) and the second solar cell chip (2), the third solar cell chip (3) and the fourth solar cell chip (4), the fifth solar cell chip (5) and the sixth solar cell chip (6).

4. The circuit stack structure for a photovoltaic assembly according to claim 1, **characterized by** the long bus bars and the short bus bars being located on the back of the solar cell strings.

## Patentansprüche

1. Schaltungsstapelstruktur für eine Photovoltaikanordnung, umfassend
einen Photovoltaikanordnungsrahmen, in dem die Photovoltaikanordnung installiert ist, wobei die Photovoltaikanordnung sechs Solarzellenketten und Sammelschienen aufweist, wobei jede Solarzellenkette durch Verbinden eine Vielzahl von Solarzellenchips in Reihe gebildet wird, und der vordere Solarzellenchip von jedem der sechs Solarzellenketten auf der Rückseite der Photovoltaikanordnung, von links nach rechts ein erster Solarzellenchip (1), ein zweiter Solarzellenchip (2), ein dritter Solarzellenchip (3), ein vierter Solarzellenchip (4), ein fünfter Solarzellenchip (5) und ein sechster Solarzellenchip (6) ist;
wobei die Sammelschienen in lange Sammelschienen und kurze Sammelschienen eingeteilt werden, wobei die langen Sammelschienen in eine erste lange Sammelschiene (7) und eine zweite lange Sammelschiene (8) eingeteilt werden und die kurzen Sammelschienen in eine erste kurze Sammelschiene (9) und in eine zweite kurze Sammelschiene (10) eingeteilt werden ,
**dadurch gekennzeichnet, dass** das linke Ende der ersten langen Sammelschiene (7) durch Löten mit dem ersten Solarzellenchip (1) verbunden ist und das rechte Ende der ersten langen Sammelschiene (7) durch Löten mit dem dritten Solarzellenchip (3) verbunden ist;
das linke Ende der zweiten langen Sammelschiene (8) durch Löten mit dem vierten Solarzellenchip (4) verbunden ist, wobei das rechte Ende der zweiten langen Sammelschiene (8) durch Löten mit dem sechsten Solarzellenchip (6) verbunden ist;
das linke Ende der ersten kurzen Sammelschiene (9) durch Löten mit dem zweiten Solarzellenchip (2) verbunden ist, wobei das rechte Ende der ersten kurzen Sammelschiene (9) als ein vorderes Ende einer Elektrode der Photovoltaikanordnung verwendet wird;
das linke Ende der zweiten kurzen Sammelschiene (10) durch Löten mit dem fünften Solarzellenchip (5) verbunden ist, wobei das rechte Ende der zweiten kurzen Sammelschiene (10) als ein vorderes Ende einer Elektrode der Photovoltaikanordnung verwendet wird.

2. Schaltungsstapelstruktur für eine Photovoltaikanordnung nach Anspruch 1, **dadurch gekennzeichnet, dass** das linke Ende der ersten langen Sammelschiene (7) durch Löten mit einer hinteren Elektrode des ersten Solarzellenchips (1) verbunden ist, wobei das rechte Ende der ersten langen Sammelschiene (7) durch Löten mit einer vorderen Elektrode des dritten Solarzellenchips (3) verbunden ist;
das linke Ende der zweiten langen Sammelschiene (8) durch Löten mit einer hinteren Elektrode des vierten Solarzellenchips (4) verbunden ist, wobei das rechte Ende der zweiten langen Sammelschiene (8) durch Löten mit einer vorderen Elektrode des sechsten Solarzellenchips (6) verbunden ist;
das linke Ende der ersten kurzen Sammelschiene (9) durch Löten mit einer vorderen Elektrode des zweiten Solarzellenchips (2) verbunden ist, wobei das rechte Ende der ersten kurzen Sammelschiene (9) als ein vorderes Ende einer negativen Elektrode der Photovoltaikanordnung verwendet wird;
das linke Ende der fünften kurzen Sammelschiene (10) durch Löten mit einer hinteren Elektrode des fünften Solarzellenchips (5) verbunden ist, wobei das rechte Ende der zweiten kurzen Sammelschiene (10) als ein vorderes Ende einer negativen Elektrode der Photovoltaikanordnung verwendet wird.

3. Schaltungsstapelstruktur für die Photovoltaikanordnung nach Anspruch 1, **dadurch gekennzeichnet, dass** zwischen dem ersten Solarzellenchip (1) und dem zweiten Solarzellenchip (2), dem dritten Solarzellenchip (3) und dem vierten Solarzellenchip (4), dem fünften Solarzellenchip (5) und den sechsten Solarzellenchip (6) Bypassdioden umgekehrt geschaltet sind.

4. Schaltungsstapelstruktur für eine Photovoltaikanordnung nach Anspruch 1, **dadurch gekennzeichnet, dass** die langen Sammelschienen und die kurzen Sammelschienen auf der Rückseite der Solarzellenketten angeordnet sind.

## Revendications

1. Structure de circuits empilés pour un ensemble photovoltaïque, comprenant
une armature pour ensemble photovoltaïque dans laquelle l'ensemble photovoltaïque est installé, l'ensemble photovoltaïque ayant six chaînes de cellules solaires et des barres omnibus, chaque chaîne de cellules solaires étant formée en connectant de multiples puces de cellules solaires en série, et la puce de cellule solaire de connexion de chacune des six chaînes de cellules solaires à l'arrière de l'ensemble photovoltaïque étant, de gauche à droite, une première puce de cellule solaire (1), une deuxième puce de cellule solaire (2), une troisième puce de cellule solaire (3), une quatrième puce de cellule solaire (4), une cinquième puce de cellule solaire (5) et une sixième puce de cellule solaire (6) ;
les barres omnibus étant classées en barres omnibus longues et barres omnibus courtes, les barres omnibus longues étant classées en première barre omnibus longue (7) et seconde barre omnibus longue (8), et les barres omnibus courtes étant classées en première barre omnibus courte (9) et seconde barre omnibus courte (10),
**caractérisée par** l'extrémité gauche de la première barre omnibus longue (7) étant connectée à la première puce de cellule solaire (1) par soudure, et l'extrémité droite de la première barre omnibus longue (7) étant connectée à la troisième puce de cellule solaire (3) par soudure ;
l'extrémité gauche de la seconde barre omnibus longue (8) étant connectée à la quatrième puce de cellule solaire (4) par soudure, l'extrémité droite de la seconde barre omnibus longue (8) étant connectée à la sixième puce de cellule solaire (6) par soudure ;
l'extrémité gauche de la première barre omnibus courte (9) étant connectée à la deuxième puce de cellule solaire (2) par soudure, l'extrémité droite de la première barre omnibus courte (9) étant utilisée en tant qu'extrémité de connexion d'une électrode de l'ensemble photovoltaïque ;
l'extrémité gauche de la seconde barre omnibus courte (10) étant connectée à la cinquième puce de cellule solaire (5) par soudure, l'extrémité droite de la seconde barre omnibus courte (10) étant utilisée en tant qu'extrémité de connexion d'une électrode de l'ensemble photovoltaïque.

2. Structure de circuits empilés pour un ensemble photovoltaïque selon la revendication 1, **caractérisée par** l'extrémité gauche de la première barre omnibus longue (7) étant connectée à une électrode arrière de la première puce de cellule solaire (1) par soudure, l'extrémité droite de la première barre omnibus longue (7) étant connectée à une électrode avant de la troisième puce de cellule solaire (3) par soudure ;
l'extrémité gauche de la seconde barre omnibus longue (8) étant connectée à une électrode arrière de la quatrième puce de cellule solaire (4) par soudure, l'extrémité droite de la seconde barre omnibus longue (8) étant connectée à une électrode avant de la sixième puce de cellule solaire (6) par soudure ;
l'extrémité gauche de la première barre omnibus courte (9) étant connectée à une électrode avant de la deuxième puce de cellule solaire (2) par soudure, l'extrémité droite de la première barre omnibus courte (9) étant utilisée en tant qu'extrémité de connexion d'une électrode négative de l'ensemble photovoltaïque ;
l'extrémité gauche de la seconde barre omnibus courte (10) étant connectée à une électrode arrière de la cinquième puce de cellule solaire (5) par soudure, l'extrémité droite de la seconde barre omnibus courte (10) étant utilisée en tant qu'extrémité de connexion de l'électrode positive de l'ensemble photovoltaïque.

3. Structure de circuits empilés pour l'ensemble photovoltaïque selon la revendication 1, **caractérisée par** des diodes de dérivation étant inversement connectées entre la première puce de cellule solaire (1) et la deuxième puce de cellule solaire (2), la troisième puce de cellule solaire (3) et la quatrième puce de cellule solaire (4), la cinquième puce de cellule solaire (5) et la sixième puce de cellule solaire (6).

4. Structure de circuits empilés pour un ensemble photovoltaïque selon la revendication 1, **caractérisée par** les barres omnibus longues et les barres omnibus courtes étant situées à l'arrière des chaînes de cellules solaires.
